Europäisches Patentamt

European Patent Office

Office européen des brevets

(11) Veröffentlichungsnummer: **0 080 462**
**B1**

(12) **EUROPÄISCHE PATENTSCHRIFT**

(45) Veröffentlichungstag der Patentschrift:
**29.01.86**

(51) Int. Cl.⁴: **H 03 K 17/04**

(21) Anmeldenummer: **82900789.7**

(22) Anmeldetag: **05.03.82**

(86) Internationale Anmeldenummer:
**PCT/DE 82/00045**

(87) Internationale Veröffentlichungsnummer:
**WO 82/04509 (23.12.82 Gazette 82/30)**

(54) **Halbleiter-Schaltungsanordnung zum Schalten einer induktiven Last.**

(30) Priorität: **15.06.81 DE 3123667**

(43) Veröffentlichungstag der Anmeldung:
**08.06.83 Patentblatt 83/23**

(45) Bekanntmachung des Hinweises auf die Patenterteilung:
**29.01.86 Patentblatt 86/5**

(84) Benannte Vertragsstaaten:
**DE FR GB**

(56) Entgegenhaltungen:
**EP - A - 0 009 957**
**GB - A - 2 025 180**
**US - A - 2 663 806**

**IBM Technical Disclosure Bulletin, vol. 15, no. 5, 4 September 1972, (Armonk, New York, US) V.A. Scotto: "Self Clamping Driver, see page 1246**

(73) Patentinhaber: **ROBERT BOSCH GMBH, Postfach 50, D-7000 Stuttgart 1 (DE)**

(72) Erfinder: **MICHEL, Hartmut, Aaranstrasse 56, D-7410 Reutlingen (DE)**
Erfinder: **GADEMANN, Lothar, Sülchenstrasse 42, D-7407 Rottenburg (DE)**
Erfinder: **JESSE, Erich, J.G. Fischer Strasse 4, D-7142 Marbach/N (DE)**

## Beschreibung

Die Erfindung betrifft eine Halbleiter-Schaltungsanordnung zum Schalten einer induktiven Last nach der Gattung des Hauptanspruchs.

Aus der GB-A-2 025 180 ist bereits eine Darlington-Transistorschaltung bekannt, die aber den Nachteil hat, dass bei ihr keine Massnahmen zur Beschaltung vorgesehen sind, die die Temperaturabhängigkeit der Transistorschaltung, insbesondere der Spannung am Kollektor berücksichtigen.

Darlington-Transistorschaltungen dieser Art finden beispielsweise vor allem in Endstufen von elektronischen Zündanlagen in Kraftfahrzeugen Anwendung, wo sie den primärseitigen Zündspulenstrom schalten.

Der Erfindung liegt demgemäss die Aufgabe zugrunde, eine Schaltungsanordnung zum Schalten einer induktiven Last zu finden, die eine Spannungsbegrenzung mit einer einstellbaren Temperaturabhängigkeit besitzt.

Denn zum Beispiel bei den in Kraftfahrzeugen vorliegenden grossen Temperaturwechseln ist die Temperaturabhängigkeit der Elektronik der Spannungsbegrenzung besonders zu berücksichtigen.

Die erfindungsgemässe Schaltungsanordnung mit den kennzeichnenden Merkmalen des Anspruchs 1 hat demnach den Vorteil, dass beim Erreichen einer bestimmten Spannung an der Kathode der Zenerdiode der Treibertransistor und der Leistungstransistor eingeschaltet werden und dass durch das Widerstandsverhältnis des ersten und des zweiten Widerstandes die Temperaturabhängigkeit dieser Einschaltspannung eingestellt werden kann. Der Vortransistor gemäss Anspruch 2 entkoppelt die Auswirkungen der Steuersignale auf die Schaltungsanordnung. Drch die Merkmale des Anspruches 3 wird erreicht, dass beim Abschalten der induktiven Last Spannungsspitzen von der steuernden Stufe ferngehalten werden. Anspruch 4 bringt den weiteren Vorteil, dass diese Einschaltspannung über das Teilerverhältnis des aus dem dritten und vierten Widerstand bestehenden Spannungsteilers auf Werte festgelegt werden kann, die weit über der Zenerspannung liegen. Anspruch 5 bringt eine zusätzliche Schaltzeitverkürzung und eine bessere Energieverteilung im Klammerbetrieb, d.h. im Bereich begrenzter Spannung am Kollektor des Darlingtonschalters. Anspruch 6 gibt an, welche der Schaltungselemente vorteilhaft monolithisch integriert werden können.

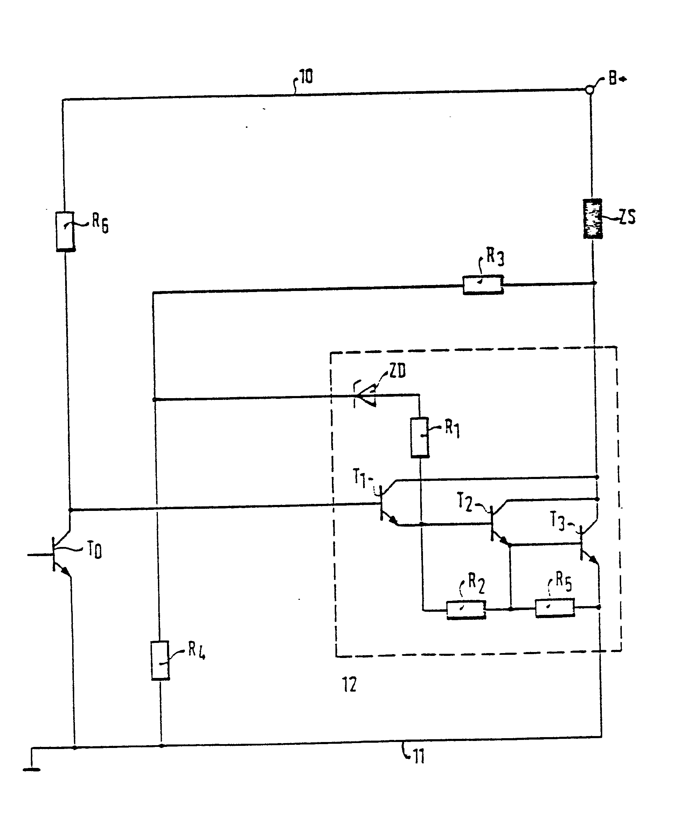

Ein Ausführungsbeispiel der erfindungsgemässen Schaltungsanordnung ist in der Zeichnung dargestellt und in der nachfolgenden Beschreibung näher erläutert.

Eine erste Betriebsstromleitung 10 ist mit der Klemme $B^+$ einer positiven Betriebsspannung verbunden. Eine zweite Betriebsstromleitung 11 ist an Masse angeschlossen. Ein npn-Leistungstransistor $T_3$ ist mit seinem Emitter an die zweite Betriebsstromleitung 11 und mit seinem Kollektor über eine induktive Last ZS an die erste Betriebsstromleitung 10 angeschlossen. Dem npn-Leitungstransistor $T_3$ ist ein npn-Treibertransistor $T_2$ vorgeschaltet. Die Kollektoren der beiden Transistoren $T_2$ und $T_3$ sind dabei miteinander verbunden, während der Emitter des Treibertransistors $T_2$ an die Basis des Leistungstransistors $T_3$ angeschlossen ist. Dem npn-Treibertransistor $T_2$ ist ein npn-Vortransistor $T_1$ vorgeschaltet. Die Kollektoren der beiden Transistoren $T_2$ und $T_1$ sind dabei wieder miteinander verbunden, während der Emitter des Vortransistors $T_1$ an die Basis des Treibertransistors $T_2$ angeschlossen ist. Die aus den drei Transistoren $T_1$, $T_2$ und $T_3$ bestehende Schaltungsanordnung wird allgemein als dreistufige Darlington-Schaltung bezeichnet. Die Basis des Vortransistors $T_1$ ist dabei durch ein Eingangssignal ansteuerbar.

An die Basis des Treribertransistors $T_2$ ist die Reihenschaltung aus einer ersten, unmittelbar an diese Basis angeschlossenen widerstand $R_1$ und einer Zenerdiode ZD angeschlossen, wobei die Anode der Zenerdiode ZD mit dem Widerstand $R_1$ verbunden ist. Ferner ist parallel zur Emitter-Basis-Strecke des Treibertransistors $T_2$ ein zweiter Widerstand $R_2$ angeordnet. Durch die Anordnung der Zenerdiode ZD und der Widerstände $R_1$ und $R_2$ wird erreicht, dass beim Erreichen einer bestimmten Spannung an der Kathode der Zenerdiode ZD der Treibertransistor $T_2$ und der Leistungstransistors $T_3$ eingeschaltet werden und dass durch das Widerstandsverhältnis der Widerstände $R_1$ und $R_2$ die Temperaturabhängigkeit dieser Einschaltspannung eingestellt werden kann.

Die Kathode der Zenerdiode ZD ist an den Abgriff eines Spannungsteilers angeschlossen, der aus einem dritten Widerstand $R_3$ und einem vierten Widerstand $R_4$ besteht. Das freie Ende des Widerstandes $R_3$ ist an den Kollektor des Leistungstransistors $T_3$ angeschlossen, während das freie Ende des Widerstandes $R_4$ an die Betriebsstromleitung 11 angeschlossen ist. Durch die Anordnung des Spannungsteilers $R_3$, $R_4$ wird erreicht, dass unabhängig von einer vorgegebenen Einschaltspannung eine günstige Zenerdiode verwendet werden kann, d.h. dass die Kollektor-Emitter-Begrenzungsspannung der Darlington-Transistorschaltung über das Teilerverhältnis dieses Spannungsteilers auf Werte festgelegt werden kann, die weit über der Zenerspannung der Zenerdiode ZD liegen.

Die Basis des Vortransistors $T_1$ ist an den Kollektor eines npn-Steuertransistors $T_0$ gelegt, dessen Emitter an die zweite Betriebsstromleitung 11 und dessen Kollektor über einen Kollektorwiderstand $R_6$ an die erste Betriebsstromleitung 10 angeschlossen ist. Parallel zur Emitter-Basis-Strecke des Leistungstransistors $T_3$ ist ein Widerstand $R_5$ im Bereich einiger Ohm vorgesehen. Diese Massnahmen führen zu einer zusätzlichen Schaltzeitverkürzung und zu einer besseren Energieverteilung im Klammerbetrieb.

Mit einem gestrichelten Linienzug 12 sind in der Zeichnung diejenigen Schaltungselemente umrandet, welche in monolithisch integrierter Form auszuführen sind.

## Patentansprüche

1. Halbleiter-Schaltungsanordnung zum Schalten einer induktiven Last mit einem Darlington-Transistorschalter bestehend aus einem Leistungs-Transistor ($T_3$) und einem Treibertransistor ($T_2$),

dessen Kollektor an den Kollektor des Leistungstransistors ($T_3$) und dessen Emitter an die Basis des Leistungstransistors ($T_3$) angeschlossen ist, und mit einer Zenerdiode (ZD) zur Begrenzung der Spannung am Kollektor des Darlington-Transistorschalters, dadurch gekennzeichnet, dass zur Einstellung der Temperaturabhängigkeit der Spannung am Kollektor an die Basis des Treibertransistors ($T_2$) die Reihenschaltung aus einem ersten, unmittelbar an diese Basis angeschlossenen Widerstand ($R_1$) und der Zenerdiode (ZD) angeschlossen ist, und dass parallel zur Emitter-Basis-Strecke des Treibertransistors ($T_2$) ein zweiter Widerstand ($R_2$) angeordnet ist.

2. Schaltungsanordnung nach Anspruch 1, dadurch gekennzeichnet, dass ein Vortransistor ($T_1$) vorgesehen ist, dessen Kollektor an den Kollektor des Leistungstransistors ($T_3$) und dessen Emitter an die Basis des Treibertransistors ($T_2$) angeschlossen ist.

3. Schaltungsanordnung nach Anspruch 2, dadurch gekennzeichnet, dass die Basis des Vortransistors ($T_1$) mit dem Kollektor eines Steuertransistors ($T_0$) verbunden ist.

4. Schaltungsanordnung nach einem der vorhergehenden Ansprüche, dadurch gekennzeichnet, dass die Zenerdiode (ZD) an den Abgriff eines aus einem dritten ($R_3$) und einem vierten ($R_4$) Widerstand bestehenden Spannungsteilers ($R_3$, $R_4$) angeschlossen ist, wobei der dritte Widerstand ($R_3$) an den Kollektor des Leistungstransistors ($T_3$) und der vierte Widerstand ($R_4$) an den Emitter des Leistungstransistors ($T_3$) angeschlossen ist.

5. Schaltungsanordnung nach einem der vorhergehenden Ansprüche, dadurch gekennzeichnet, dass parallel zur Emitter-Basis-Strecke des Leistungsstransistors ($T_3$) ein fünfter Widerstand ($R_5$) vorgesehen ist.

6. Schaltungsanordnung nach einem der vorhergehenden Ansprüche, dadurch gekennzeichnet, dass der Leistungstransistors ($T_3$), der Treibertransistor ($T_2$), die Zenerdiode (ZD), der erste Widerstand ($R_1$), und der zweite Widerstand ($R_2$) sowie, gemäss Patentanspruch 2, der Vortransistor ($T_1$) und, gemäss Patentanspruch 5, der fünfte Widerstand ($R_5$) monolithisch integriert sind.

## Claims

1. Semiconductor circuit arrangement for the switching of an inductive load with a Darlington transistor switch, consisting of a power transistor ($T_3$) and a driving transistor ($T_2$), the collector of which is connected to the collector of the power transistor ($T_3$) and the emitter of which is connected to the base of the power transistor ($T_3$), and with a Zener diode (ZD) for the restriction of the voltage at the collector of the Darlington transistor switch, characterised in that in order to set the temperature dependence of the voltage at the collector there is connected to the base of the driving transistor ($T_2$) the series circuit consisting of a first resistor ($R_1$) directly connected to this base and the Zener diode (ZD), and in that the a second resistor ($R_2$) is disposed in parallel with the emitter-base section of the driving transistor ($T_2$).

2. Circuit arrangement according to Claim 1, characterised in that a front transistor ($T_1$) is provided, the collector of which is connected to the collector of the power transistor ($T_3$) and the emitter of which is connected to the base of the driving transistor ($T_2$).

3. Circuit arrangement according to Claim 2, characterised in that the base of the front transistor ($T_1$) is connected to the collector of a control transistor ($T_0$).

4. Circuit arrangement according to one of the preceding claims, characterised in that the Zener diode (ZD) is connected to the tap of a voltage divider ($R_3$, $R_4$) consisting of a third ($R_3$) and a fourth ($R_4$) resistor, the third resistor ($R_3$) being connected to the collector of the power transistor ($T_3$) and the fourth resistor ($R_4$) being connected to the emitter of the power transistor ($T_3$).

5. Circuit arrangement according to one of the preceding claims, characterised in that a fifth resistor ($R_5$) is provided in parallel with the emitter-base section of the power transistor ($T_3$).

6. Circuit arrangement according to one of the preceding claims, characterised in that the power transistor ($T_3$), the driving transistor ($T_2$), the Zener diode (ZD), the first resistor ($R_1$), and the second resistor ($R_2$), as well as, according to Patent Claim 2, the front transistor ($T_1$) and, according to Patent Claim 5, the fifth resistor ($R_5$), are monolithically integrated.

## Revendications

1. Circuit de commutation à semiconducteur pour commuter une charge inductive avec un commutateur à transistors en montage Darlington, se composant d'un transistor de puissance ($T_3$) et d'un transistor de commande ($T_2$) dont le collecteur est relié au collecteur du transistor de puissance ($T_3$) et dont l'émetteur est relié à la base du transistor de puissance ($T_3$), et une diode Zener (ZD) pour limiter la tension du collecteur du montage é transistors de type Darlington, caractérisé en ce que pour régler la fonction de température de la tension sur le collecteur, la base du transistor de commande ($T_2$) est branchée sur un montage en série formé d'une première résistance ($R_1$) reliée directement à cette base et d'une diode Zener (ZD) et en ce qu'en parallèle sur le chemin émetteur-base du transistor de commande ($T_2$), il est prévu une seconde résistance ($R_2$).

2. Circuit de commutation selon la revendication 1, caractérisé en ce qu'il comporte un transistor amont ($T_1$) dont le collecteur est relié au collecteur du transistor de puissance ($T_3$) et dont l'émetteur est relié à la base du transistor de commande ($T_2$).

3. Circuit de commutation selon la revendication 2, caractérisé en ce que la base du transistor amont ($T_1$) est reliée au collecteur d'un transistor de commande ($T_0$).

4. Circuit de commutation selon l'une des revendications précédentes, caractérisé en ce que la diode Zener (ZD) est reliée à la prise de sortie d'un diviseur de tension ($R_3$, $R_4$) composé d'une troisième ré-

sistance (R$_3$) et d'une quatrième résistance (R$_4$), la troisième résistance (R$_3$) étant reliée au collecteur du transistor de puissance (T$_3$) et la quatrième résistance (R$_4$) étant reliée à l'émetteur du transistor de puissance (T$_3$).

5. Circuit de commutation selon l'une des revendications précédentes, caractérisé en ce qu'en parallèle sur le chemin émetteur-base du transistor de puissance (T$_3$), il est prévu une cinquième résistance (R$_5$).

6. Circuit de commutation selon l'une des revendications précédentes, caractérisé en ce que le transistor de puissance (T$_3$), le transistor de commande (T$_2$), la diode Zener (ZD), la première résistance (R$_1$) et la seconde résistance (R$_2$) ainsi que selon la revendication 2, la résistance amont (T$_1$) et selon la revendication 5, la cinquième résistance (R$_5$) sont intégrés sous forme monolithique.